## Europäisches Patentamt
## European Patent Office
## Office européen des brevets

(19)

(11) Numéro de publication: **0 052 025 B1**

(12) # FASCICULE DE BREVET EUROPEEN

(45) Date de publication du fascicule du brevet:
16.01.85

(51) Int. Cl.⁴: **H 05 K 5/02**, H 05 K 7/12

(21) Numéro de dépôt: 81401553.3

(22) Date de dépôt: 07.10.81

(54) **Dispositif de fixation d'un élément amovible, en particulier d'un cabochon de voyant lumineux, dans un réceptacle.**

(30) Priorité: 05.11.80 FR 8023646

(43) Date de publication de la demande:
19.05.82 Bulletin 82/20

(45) Mention de la délivrance du brevet:
16.01.85 Bulletin 85/3

(84) Etats contractants désignés:
DE GB IT NL

(56) Documents cités:
FR - A - 2 315 783
FR - A - 2 340 018
FR - A - 2 389 214

(73) Titulaire: **L'EQUIPEMENT ET LA CONSTRUCTION ELECTRIQUE en abrégé E.C.E. Société dite :, 157, rue Pelleport, F-75020 Paris (FR)**

(72) Inventeur: **Jullien, Gérard Michel René, Les Marronniers Appartment 13-1 36 rue de Picpus, F-75012 Paris (FR)**

(74) Mandataire: **Barnay, André François et al, Cabinet Barnay 80 rue Saint-Lazare, F-75009 Paris (FR)**

ACTORUM AG

## Description

L'invention se rapporte à un dispositif de fixation d'un élément amovible dans un réceptacle, en particulier d'un cabochon de voyant lumineux dans un réceptacle monté sur un panneau, l'élément introduit dans le réceptacle s'y trouvant sollicité dans le sens de son éjection par des organes élastiques que contient le réceptacle, tels que des pistons de contact à ressort destinés à assurer l'alimentation électrique d'ampoules placées dans un cabochon. De tels dispositifs sont connus par exemple du document FR-A-2389214.

L'invention a pour but de créer un dispositif de ce genre, capable de maintenir l'élément amovible dans son réceptacle où il est soumis à l'action desdites organes élastiques qui tendent à l'éjecter, la retenue de l'élément amovible devant pouvoir être aisément supprimée pour permettre son éjection hors du réceptacle. Ce dispositif doit de plus être simple et occuper un volume négligeable.

Le dispositif qui fait l'objet de la présente invention est caractérisé par le fait qu'il comprend une languette élastique solidaire de la paroi du réceptacle et faisant saillie obliquement à l'intérieur de celui-ci suivant une direction telle que ladite languette s'efface élastiquement au passage de l'élément amovible lorsqu'il est introduit dans le réceptacle, puis reprend sensiblement sa position naturelle en pénétrant dans un évidement pratiqué dans la paroi adjacente de l'élément amovible et en retenant alors ce dernier par effet de butée de son extrémité contre le bord postérieur dudit évidement, tandis qu'un jeu est prévu entre les parois adjacentes du réceptacle et de l'élément amovible, permettant d'introduire entre celles-ci une lame pour faire s'effacer à l'aide de cette lame ladite languette et libérer ainsi l'élément amovible, qui est alors éjecté du réceptacle par lesdits organes élastiques.

L'évidement de l'élément amovible est avantageusement un évidement borgne, c'est-à-dire qu'il présente la forme d'une cuvette comportant un fond et des bords. Il a de préférence un contour rectangulaire.

Dans une forme d'exécution préférée, la dimension longitudinale de l'évidement, comptée dans la direction d'introduction de l'élément amovible dans le réceptacle, est telle qu'elle y permet un enfoncement supplémentaire de l'élément amovible au delà de sa position de retenue par la languette, ce qui est utile pour la commande éventuelle de contacts électriques incorporés au réceptacle.

La languette élastique de verrouillage peut être rapportée sur la paroi du réceptacle. Elle est alors de préférence fixée sur la face extérieure de celle-ci et émerge à l'intérieur du réceptacle par une fenêtre pratiquée dans ladite paroi. La languette peut aussi faire partie intégrante de la paroi du réceptacle et être réalisée par découpage et cambrage d'une partie de celle-ci.

La forme de l'élément amovible est quelconque; il suffit qu'il puisse pénétrer par coulissement dans son réceptacle.

Le dispositif de fixation selon l'invention se distingue par sa simplicité, son faible encombrement (les dimensions générales de l'élément amovible et du réceptacle étant à peine modifiées), sa fiabilité vis-à-vis des influences mécaniques (chocs et vibrations) et sa facilité d'utilisation.

La description qui va suivre, en regard des dessins annexés à titre d'exemple non limitatif, permettra de bien comprendre comment l'invention peut être mise en pratique.

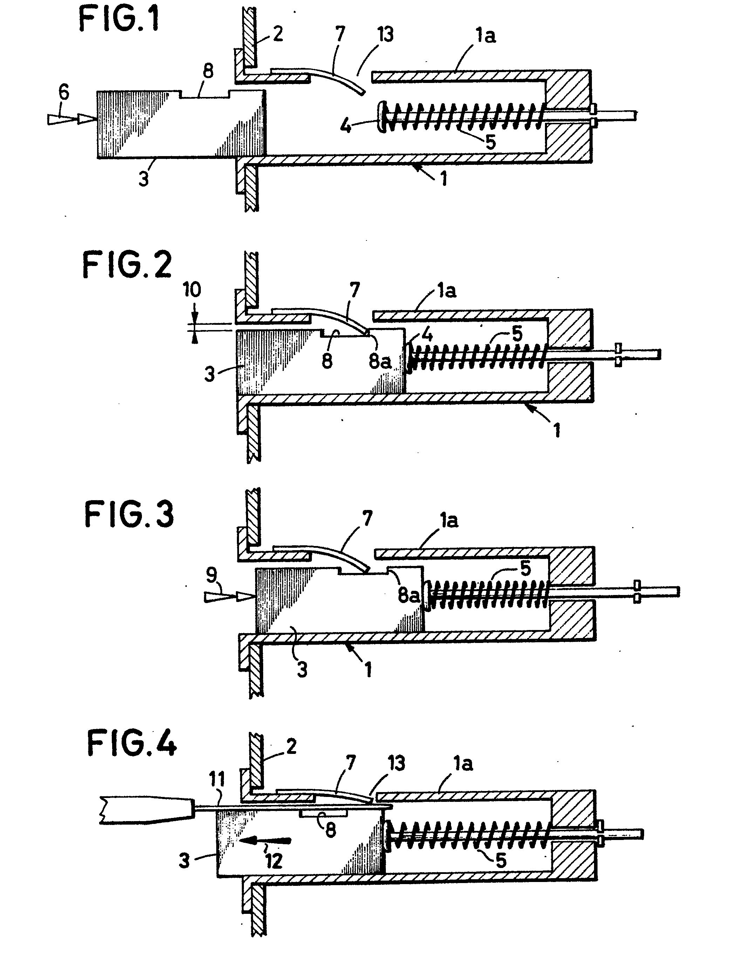

Les figures 1 à 4 représentent en coupe longitudinale un élément amovible et son réceptacle incorporant un dispositif de fixation selon l'invention, l'élément amovible étant respectivement en début de course d'introduction dans le réceptacle, en position de fixation normale, en position d'enfoncement, supplémentaire et en cours d'éjection hors du réceptacle.

On voit sur les figures un réceptacle 1 cyclindrique ou prismatique fixé à un panneau 2 et destiné à recevoir un élément amovible 3 constitué ici par un cabochon portelampes de voyant lumineux, dont les ampoules électrique sont alimentées, lorsqu'il a pris sa position normale dans le réceptacle 1 (figure 2), par des pistons mobiles 4 associés à des ressorts 5. Les ampoules et les pistons 4 sont en nombre quelconque.

La mise en place dans le réceptacle 1 du cabochon 3 se fait en introduisant celui-ci par poussée suivant la flèche 6 (figure 1), du côté du panneau 2 opposé à celui où se trouve le réceptacle 1. Vers la fin de la course d'introduction du carbochon 3, celui-ci rencontre les pistons 4 qui reculent élastiquement en exerçant une contre-poussée.

Lorsque le cabochon a atteint sa position normale (figure 2), une languette élastique 7, qui s'avance obliquement à l'intérieur du réceptacle 1 et s'était effacée au passage du cabochon 3 vers la paroi 1a du réceptacle 1 à laquelle elle est fixée, reprend sensiblement sa position naturelle et s'engage dans un évidement 8 en forme de cuvette rectangulaire qu'offre le cabochon 3. Cette languette 7 retient alors par encliquetage et verrouille le cabochon 3, le bord postérieur 8a de l'évidement 8 de ce dernier butant contre l'extrémité de la languette 7 sous l'effort des ressorts 5.

La figure 3 montre que la cuvette 8 a une longueur telle qu'elle ne s'oppose pas à un enfoncement supplémentaire du cabochon 3 sous une nouvelle poussée (flèche 9) à l'encontre de l'action des ressorts 5, par exemple dans le but de commander des contacts électriques (non représentés) à la manière d'un bouton-poussoir. A la cessation de la poussée 9, le cabochon revient dans sa position normale (figure 2) sous l'action de rappel des ressorts 5.

Si l'on désire ôter le cabochon 3 de son réceptacle 1, il suffit d'introduire entre la paroi 1a de celui-ci et le cabochon 3, grâce à un jeu 10 prévu à cet effet (figure 2), la lame 11 d'un outil de déverrouillage (figure 4) qui fait sortir la languette 7 de la cuvette 8 et libère le cabochon 3, lequel est éjecté suivant la flèche 12 par la détente des ressorts 5.

Dans la forme d'exécution représentée, 1a languette 7, de forme incurvée, est fixée, par exemple par soudure, à la face extérieure de la paroi 1a du réceptacle 1, et émerge à l'intérieur de ce dernier à travers une fenêtre 13 pratiquée dans cette paroi, fenêtre dans laquelle la languette 7 peut s'éclipser sous l'action de la lame 11 de l'outil de déverrouillage.

La forme de la section droite du cabochon 3 et du réceptacle 1 associé peut être quelconque, par exemple carrée, rectangulaire ou circulaire.

## Revendications

1. Dispositif de fixation d'un élément amovible (3) dans un réceptacle, en particulier d'un cabochon de voyant lumineux dans un réceptacle (1) monté sur un panneau (2), l'élément introduit dans le réceptacle s'y trouvant sollicité dans le sens de son éjection par des organes élastiques (4, 5) que contient le réceptacle (1), tels que des pistons de contact à ressort destinés à assurer l'alimentation électrique d'ampoules placées dans un cabochon, ce dispositif étant caractérisé par le fait qu'il comprend une languette élastique (7) solidaire de la paroi (1a) du réceptacle (1) et faisant saillie obliquement à l'intérieur de celui-ci suivant une direction telle que ladite languette s'efface élastiquement au passage de l'élément amovible (3) lorsqu'il est introduit dans le réceptacle (1), puis reprend sensiblement sa position naturelle en pénétrant dans un évidement (8) pratiqué dans la paroi adjacente de l'élément amovible (3) et en retenant alors ce dernier par effet de butée de son extrémité contre le bord postérieur (8a) dudit évidement, tandis qu'un jeu (10) est prévue entre les parois adjacentes du réceptacle (1) et de l'élément amovible (3), permettant d'introduire entre celles-ci une lame (11) pour faire s'effacer à l'aide de cette lame ladite languette (7) et libérer ainsi l'élément amovible (3), qui est alors éjecté du réceptacle (1) per lesdits organes élastiques (4, 5).

2. Dispositif selon la revendication 1, caractérisé par le fait que l'évidement (8) est un évidement borgne, c'est-à-dire qu'il présente la forme d'une cuvette comportant un fond et des bords.

3. Dispositif selon la revendication 1 ou 2, caractérisé par le fait que l'évidement (8) a un contour rectangulaire.

4. Dispositif selon l'une quelconque des revendications 1 à 3, caractérisé par le fait que la dimension longitudinale de l'évidement (8) est telle qu'elle permet un enfoncement supplémentaire de l'élément (3) dans le réceptacle (1) au delà de sa position de retenue par la languette (7).

5. Dispositif selon l'une quelconque des revendications 1 à 4, caractérisé par le fait que la languette (7) est fixée sur la face extérieure de la paroi (1a) du réceptacle (1) est émerge à l'intérieur de celui-ci par une fenêtre (13) pratiquée dans ladite paroi.

6. Dispositif selon l'une quelconque des revendications 1 à 4, caractérisé par le fait que la languette (7) est réalisée par découpage et cambrage d'une partie de la paroi (1a) du réceptacle (1).

## Patentansprüche

1. Vorrichtung zum Befestigen eines herausziehbaren Elements (3) in einer Aufnahmevorrichtung, insbesondere einer in einer Platte (2) angeordneten Anzeigelampenbaueinheit in einer Aufnahmevorrichtung (1), wobei das in die Aufnahmevorrichtung eingesetzte Element von in der Aufnahmevorrichtung (1) enthaltenen elastischen Elementen (4, 5) im Sinne seiner Auswurfrichtung derart kraftbeaufschlagt ist, dass durch Kolbenfederkontakte die elektrische Versorgung von in einer Abdeckscheibe angeordneten Glühbirnen gewährleistet ist, dadurch gekennzeichnet, dass die Vorrichtung eine an der Wand (1a) der Aufnahmevorrichtung (1) befestigte elastische Zunge (7) aufweist, die in deren Inneres in solcher Richtung schräg vorspringt, dass die Zunge beim Einschieben des herausziehbaren Elements (3) elastisch beiseite gedrückt wird, bis es in die Aufnahmevorrichtung (1) eingeführt ist, dann ihre natürliche Lage im wesentlichen wieder einnimmt, in dem sie in eine Aussparung (8) eintritt, die in der dem herausziehbaren Element (3) angrenzenden Wand vorgesehen ist und somit dieses dadurch zurückhält, dass sich ihr Ende gegen den hinteren Rand (8a) der Aussparung abstützt, wobei zwischen den einander angrenzenden Wänden der Aufnahmevorrichtung (1) und des herausziehbaren Elements (3) ein Spiel (10) vorgesehen ist, das es erlaubt, zwischen diese eine Klinge (11) einzuführen, um die Zunge (7) mit Hilfe der Klinge beiseite zu drücken und das herausziehbare Element (3) zu lösen, das dann aus der Aufnahmevorrichtung (1) durch die elastischen Elemente (4, 5) ausgeworfen wird.

2. Vorrichtung nach Anspruch 1, dadurch gekennzeichnet, dass die Aussparung (8) als Blindaussparung ausgebildet ist, d.h. dass sie die Form einer, einen Boden und Seitenränder aufweisenden, Mulde besitzt.

3. Vorrichtung nach Anspruch 1 oder 2, dadurch gekennzeichnet, dass die Aussparung (8) rechteckigen Umriss besitzt.

4. Vorrichtung nach einem der Ansprüche 1 bis 3, dadurch gekennzeichnet, dass die Abmessung der Aussparung (8) in Längsrichtung so gewählt ist, dass sie über die Halteposition durch die Zunge (7) hinausgehend ein weiteres Eindrücken des Elements (3) in der Aufnahme (1) erlaubt.

5. Vorrichtung nach einem der Ansprüche 1 bis 4, dadurch gekennzeichnet, dass die Zunge (7) auf der Aussenseite der Wand (1a) der Aufnahmevorrichtung (1) befestigt ist und durch ein in dieser Wand vorgesehenes Fenster (13) ins Innere der Aufnahmevorrichtung (1) vorsteht.

6. Vorrichtung nach einem der Ansprüche 1 bis 4, dadurch gekennzeichnet, dass die Zunge (7) durch Freischneidung und Abbiegen eines Teils der Wand (1a) der Aufnahmevorrichtung (1) gebildet ist.

## Claims

1. Device for fixing a removable element (3) in a receptacle, in particular an indicator light unit in a receptacle (1) mounted on a panel (2), the element introduced into the receptacle being urged in the direction of its ejection by resilient means (4, 5) located in the receptacle (1), such as spring-loaded pistons serving to provide the electrical supply to bulbs located in a unit, the device being characterized by comprising an elastic tongue (7) connected to the wall (1a) of the receptacle (1) and directed obliquely toward the interior thereof in such a direction that the tongue yields elastically to the passage of the removable element (3) when it is introduced into the receptacle (1) and then substantially resumes its natural position, by penetrating into a recess (8) formed in the adjacent wall of the removable element (3) and then retaining the latter due to abutment of its extremity against the rear end (8a) of such recess, a clearance (10) being provided between the adjacent walls of the receptacle (1) and the removable element (3) to permit introduction between them of a blade (11) so as to displace the tongue (7) by means of such blade and so free the removable element (3), which is then ejected from the receptacle (1) by the resilient means (4, 5).

2. Device according to claim 1, characterized in that the recess (8) is a shallow recess, that is it has the form of a cut-out including a base and edges.

3. Device according to claim 1 or 2, characterized in that the recess (8) has a rectangular periphery.

4. Device according to any of claims 1 to 3, characterized in that the longitudinal dimension of the recess (8) is such that it allows a supplementary insertion of the element (3) into the receptacle (1) beyond its position of retention by the tongue (7).

5. Device according to any of claims 1 to 4, characterized in that the tongue (7) is fixed to the exterior surface of the wall (1a) of the receptacle (1) and passes into the interior thereof through a window (13) made in such wall.

6. Device according to any of claims 1 to 4, characterized in that the tongue (7) is formed by cutting out and bending a part of the wall (1a) of the receptacle (1).

# FIG.1

# FIG.2

# FIG.3

# FIG.4